# EUROPEAN PATENT APPLICATION

(11) **EP 0 718 905 A1**
(43) Date of publication of application: **26.06.1996**
(21) Application number: 94120275.6
(22) Date of filing: 21.12.1994
(51) Int. Cl.: H01P 1/00, H01P 3/00, H01L 23/66

(54) **Surface mountable microwave IC package**

(71) Applicant: INDUSTRIAL TECHNOLOGY RESEARCH INSTITUTE, Chutung, Hsinchu 31015 (TW)
(72) Inventor: Lin, Chao-Hui, Hsinchu, Taiwan 310 (TW)
(74) Representative: Schmidt-Bogatzky, Jürgen, Dr.-Ing. Huth, Dietrich & Partner

(57) **Abstract**

A surface mountable microwave IC package with broad bandwidth and low loss has been developed. The impedance mismatch due to the electrical discontinuity of the I/O pads and via holes in the structure is compensated. The compensation structure has two features. In one feature, ground planes are printed on both sides of a dielectric substrate to increase the distributed capacitance between the signal line and the ground, thereby obtaining a matched characteristic impedance. In the second feature, two grounding via holes are used to compensate for the mismatch of the characteristic impedance due to the feedthrough connection of the signal line from the back-side to the front-side of the substrate.

## Description

### BACKGROUND OF THE INVENTION

### 1. Field of the Invention

The present invention relates to integrated circuit (IC) packages, and more particularly to a surface mountable microwave IC package which provides high performance with a very low cost.

### 2. Description of the Prior Art

The performance of microwave gallium-arsenide (GaAs) integrated is limited by the package in which the ICs are mounted. Typical packages with a reasonable cost, such as the one described in U.S. Patent No. 5,014,115 issued May 7, 1991, entitled "COPLANAR WAVEGUIDE SEMICONDUCTOR PACKAGE" by Lester J. Moser, are usually limited in operating frequency, from DC to several gigahertz. Their functions and performance, such as surface mountability, loss, size, and other characteristics, leave much to be desired. High performance packages, such as the Hypcon described in U.S. Patent No. 4,255,003 issued March 10, 1981 entitled "ELECTRICAL CONNECTOR" by William E. Berg and the one described in U.S. Patent No. 4,626,805 issued December 02, 1986 entitled "SURFACE MOUNTABLE MICROWAVE IC PACKAGE" by Keith E. Jones, are very complex and expensive. The Jones package is preferred among international products. Its operating frequency extends from DC to twelve gigahertz, but the cost is very high.

What is desired is a low cost, high performance, miniature size, surface mountable GaAs microwave IC carrier.

### SUMMARY OF THE INVENTION

An object of this invention is to provide a high performance, surface mountable microwave IC package with broad bandwidth and low loss. Another object is to provide a low cost microwave IC package. Still another object is to provide a package which does not require expensive brazing and thin-film techniques.

These objects are achieved by using thick-film technique. Distributed capacitance is used to compensate for the impedance mismatch due to the I/O pads and the via holes, yielding a matching impedance of 50 ohms directly. Lumped capacitance-inductance matching technique is not used to avoid forming a low-pass filter, which limits the frequency response. This structure results in perfect impedance matching and broad bandwidth.

### BRIEF DESCRIPTION OF THE DRAWINGS

- Fig. 1: shows the front-side layout of this invention.
- Fig. 2: shows the back-side layout of this invention.
- Fig. 3: shows the overlay of the front-side layout and the back-side layout.
- Fig. 4: (a) shows the top view of the metal cap and

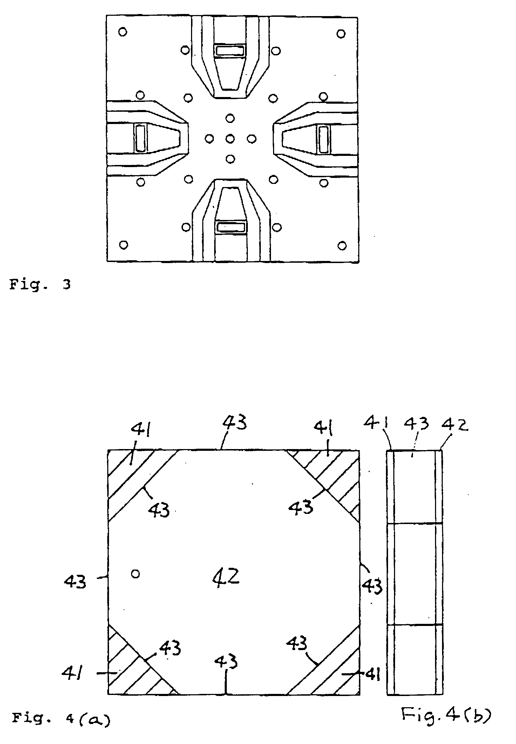

- Fig. 4: (b) shows the side view of the metal cap.

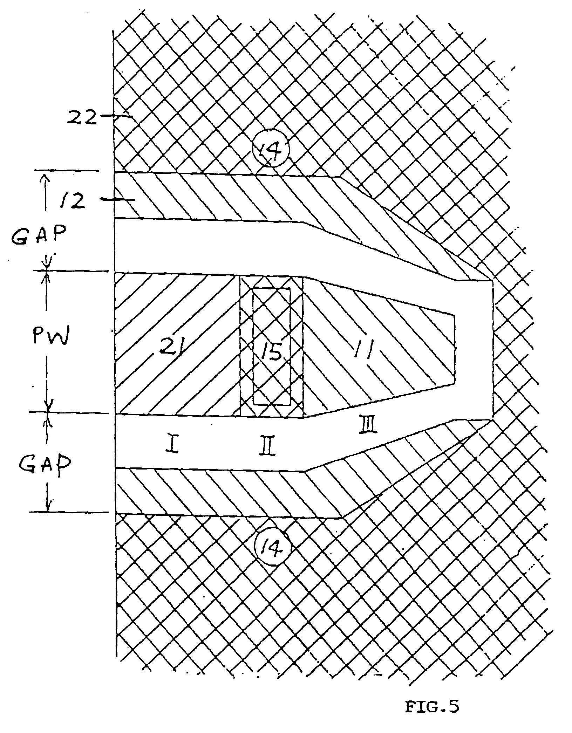

- Fig. 5: shows a single port structure comprising three sections labelled as I, II and III according to this invention.

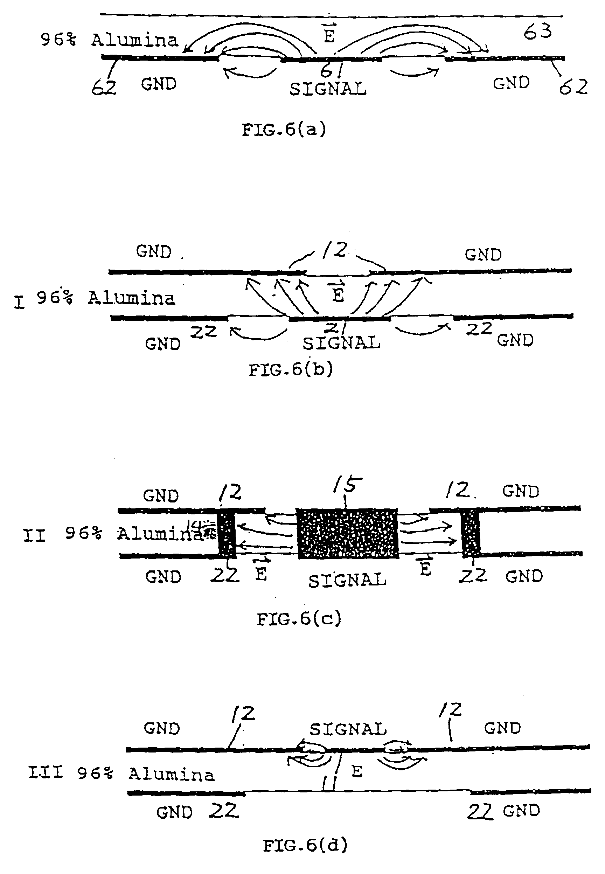

- Fig. 6: (a) shows a coplanar waveguide structure.

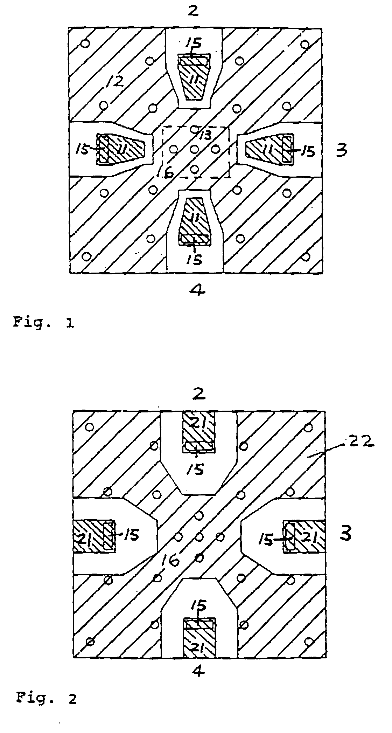

- Fig. 6: (b) - (d) are the side views of section I, section II and section III in Fig. 5, which is an enlarged view of the input port 1 in Fig. 1. Fig. 6 (b) shows a compensated pseudo-CPW structure. Fig. 6 (c) shows a compensated via-slot structure. Fig. 6 (d) shows a pseudo-CPW structure.

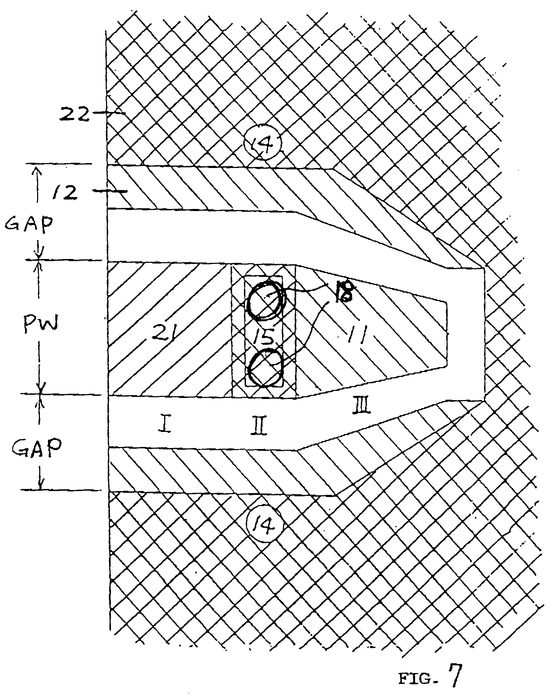

- Fig. 7: shows another single-port structure corresponding to Fig. 5 according to another embodiment of this invention.

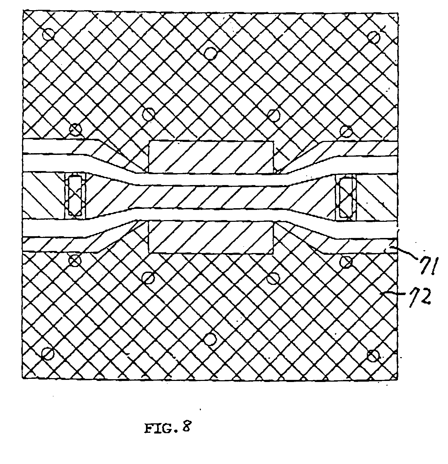

- Fig. 8: shows the test circuit of this invention.

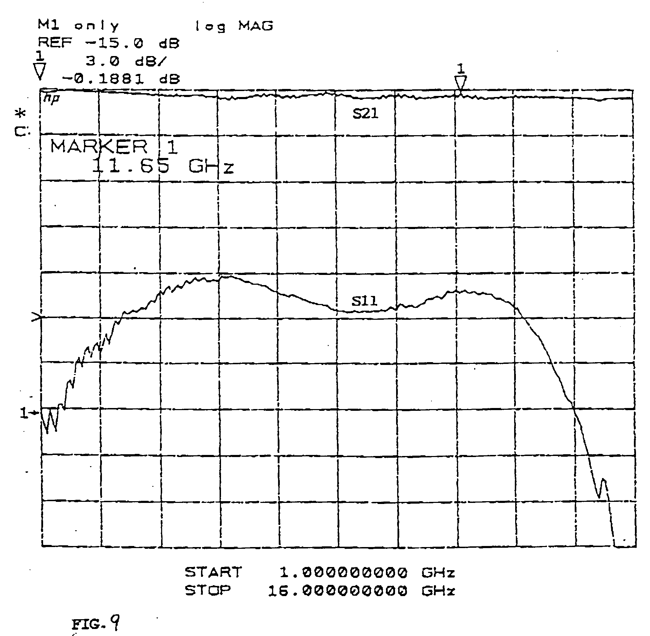

- Fig. 9: shows the measured S-parameters S21 and S11 of this new structure.

### DESCRIPTION OF THE PREFERRED EMBODIMENT

The structure of this invention has two parts. One part is the main body as shown in Fig. 3. The other part is a metal cap as shown in Fig. 4, which is adhered to the main body to prevent electro-magnetic interference. The main body is composed of three layers: (a) a dielectric substrate with via-holes in it; (b) printed circuits on the front side of the substrate as shown in Fig. 1, and (c) printed circuits on the back-side of the substrate as shown in Fig. 2.

The structure can be divided into two electrical parts: (a) the input/output (I/O) ports of the package (1, 2, 3, 4 in Fig. 1 and Fig. 2); (b) the ground plane which supports both the ground connection for a monolithic microwave IC (MMIC) and an impedance compensation structure. The number and the location of the I/O ports depend on the application. As an example, a four-port structure is described here for use to package a MMIC low noise block (LNB) in a direct broadcast system (DBS).

Referring to Fig. 1 and Fig. 2, the printed circuits on the front-side and back-side have ground planes 12 and 22 (45° crosshatched area) connected by a number of metal-filled circular holes 16. There are four I/O ports 1, 2, 3, 4. Each port includes an electrical signal line comprising three physical sections: a wire-bonding pad 11 on the front-side of the dielectric substrate, a soldering pad 21 on the back-side of the dielectric substrate, and a metal-filled via-slot 15 imbedded in the substrate and connecting the soldering pad and the wire-bonding pad. The MMIC is placed on the die cavity 13 of the front-side ground plane 12. The signal ports of the MMIC are wire-bonded to the wire-bonding pad 11 of the I/O ports of the package. The space between the crosshatched areas is the clear surface of the substrate. The metal portions can be fabricated with conventional thick-film or thin-film techniques. The metal can be gold, silver, copper,..., etc, each having advantages and disadvantages. In this figure, the thick-film was used. The front-side metal is gold, and the back-side metal is silver. The reason why the thick-film technique is used is that the thick-film technique is much cheaper than the thin-film technique. The front-side gold can easily be wire-bonded and is not erosive, but can easily be attacked by lead solder. Silver is used in the back-side, for it can avoid the attack of the soldering lead and the cost is lower than gold, but silver cannot easily be wire-bonded and can react with sulfer. Copper is a cheaper material and can hardly be attacked by solder, but is costly to fabricate and chemically reactive (or unstable). The material for the dielectric substrate can be any material suitable for microwave applications, such as alumina (Al₂O₃), alumina nitride, sapphire, quartz, etc., and other printed board materials such as Duriod, Teflon, etc. This example adopted 96% alumina as the base plate for its high dielectric constant (to reduce the circuit area), low loss, and regidity. Aluminium nitride, sapphire and quartz also possess the advantages and therefore can also be used. Aluminium nitride has the additional advantage of having high thermal conductivity to dissipate heat. Alternatively, silver is selected as the front-side metal and Pd/Ag alloy is selected as the back-side metal.

The top view and the side view of the shielding metal cap of the package is shown in Fig. 4 (a), the top view, and Fig. 4 (b), the side view. The cap is of the same size as the package and is constructed with brass, covar (an alloy of Fe, Co and Ni), alloy 42, etc. As shown in Fig. 4 (a), the metal cap has a hexagonal shape with eight walls 43 which connect the central upper plate 42 to the four lower plates 41 as shown in Fig. 4 (b) at the four conners. With these four lower plates 41, the cap is attached to the front-side ground of the package by conductive epoxy.

Fig.'s 5 and 6 show the distributed compensation structure of the I/O port in detail. Fig. 5 shows the overlay of the front-side and the back-side of a single-port structure. The 45° crosshatched areas 15, 21, 22 are the back-side metal, and the 135° crosshatched areas 11, 12, 15 are the front-side metal. By the metal-filled slot 15, the two signal lines 11 and 12 are connected, and by the metal-filled holes 14 which are situated near and at the two sides of the slot with equal spacing from the edges of the slot, the two ground planes 12 and 22 are shorted. Fig. 6 (b), Fig. 6 (c) and Fig. 6 (d) are the views of section I, section II and section III in Fig. 5. The conventional structure of a coplanar waveguide (CPW) is shown in Fig. 6 (a). The front-side of the substrate 63 is clear without any metal. On the other side, three parallel metal lines 61 and 62 with equal spacing between them are printed. The central line 61 is the signal line, and the other two lines 62 are the ground planes. The electric fields distributed between them are confined in the substrate because the dielectric constant of the alumina substrate is high. Once the dielectric constant and the depth of the substrate is chosen, the characteristic impedance is determined by the width of the central line and the spacing between 61 and 62. The narrower the spacing is, the larger is the distributed capacitance and the lower is the characteristic impedance. To provide a good adhesion of the package to the PC board in SMT process and to prevent short circuit, the I/O pad-width PW of the soldering pad 21, as shown in Fig. 5, and its spacing GAP to ground plane 22 must be larger enough to satisfy some commercial rules. Usually, PW is in the range between 1-1.2mm; GAP between 0.8-1mm. Under this rule, the spacing is too wide such that the characteristic impedance of the soldering pad 21 rises above 80 ohms which causes impedance mismatch and greatly degrades the package performance.

To overcome this disadvantage, this invention utilizes two extended ground planes 12 on the upper plane of the package to provide more distributed capacitance for the pad 21, thus reducing the characteristic impedance of the soldering pads 21 from 80 ohms to 50 ohms. A side view of such a compensated pseudo-CPW structure corresponding to the first section I of Fig. 5 is illustrated in Fig. 6 (b). The inventive structure is named as "compensated pseudo-CPW structure" since it is different from the conventional CPW structure in Fig. 6 (a) or CPWG (CPW gated) structure.

The other high-impedance element in conventional microwave package that degrades the performance of the package is the via hole for connecting the signal line on the two sides of the substrate, which is equivalent to a pure inductor. There are two ways to compensate for this inductance so as to reduce the impedance to 50 ohms. One method is to reduce the inductance, and the other is to add distributed capacitance. Instead of using traditional circular via holes, this invention uses broadened metal-filled slot 15, as shown in Fig. 5, to simultaneously reduce the inductance and add more distributed capacitance as indicated in Fig. 6 (c). Moreover, the structure uses two compensating ground holes 14 among the ground holes 16 which short the two ground planes 12 and 22 and are situated near and at the two opposite sides of the slot, as shown in Fig. 5 and Fig. 6 (c), and in equal spacing to the slot to increase the distributed capacitance of the slot 15. In Fig. 5, section III, a 50 ohm taper shaped wire-bonding pad on the front side of the plate is used. Section III is also formed as a pseudo-CPW structure as shown by the side-view in Fig. 6 (d). As the gap between the signal line 11 and the ground 12 is narrow, the electric field is almost entirely confined in the gap, as indicated by the short electric lines E in Fig. 6 (d). Thus, the effect from the back-side ground 22 can be ignored.

It has been demonstrated that this distributed compensation structure can render all the three sections of the signal line (pad 11 and 21, metal-filled via slot 15) to become the standard 50 ohm transmission line over broad frequencies, instead of performing like a low-pass filter as in most of the prior art.

As mentioned above, this invention adopts a metal-filled slot 15 imbedded in the substrate instead of a single metal-filled via hole to transfer I/O signal between the soldering pad and the wire-bonding pad. In another embodiment of this invention, a plurality of metal-filled via holes are arranged in alignment and situated in the original location of the slot 15 to replace the metal-filled slot structure. Fig. 7 is a single-port structure according to such an embodiment wherein double metal-filled via holes 18, in alignment with the metal-filled holes 14, are utilized instead of the metal-filled slot structure in Fig. 5. That is to say, a plurality of metal-filled via holes in alignment can simulate the function of a metal-filled via slot structure.

Fig. 8 is the test circuit of this invention. The 45° crosshatched area 71 is the front-side layout and the 135° crosshatched area 72 is the back-side layout. The difference between the package and the test fixture is that the test fixture has an extra 50-ohm line for connecting two I/O ports. The other two ports are not used. The measured result is shown in Fig. 9. The measured frequency range is limited to 16 GHz due to the reliability of the system and SMA connectors. One can see that the average reflection coefficient (S11) is below -15 dB, and the average transmission coefficient (S21) is within -0.2 dB over a very broad bandwidth 1 - 16 GHz. In other words, the package is nearly lossless. In fact, the loss includes three types of losses:
1. loss from two I/O ports
2. loss from the extra 50-ohms line
3. loss from the two SMA connectors, which dominates the loss.

## Claims

1. A surface mountable microwave package comprising: a dielectric plate, a first ground plane (12) of metal printed on the front-side of said plate, a second ground plane (22) of metal printed on the back-side of said plate, via holes (16) in said plate for connecting the first ground plane (12) to the second ground plane (22) with metal, at least one input/output port having a signal line including a soldering pad (21) of metal on the back-side of said plate, said soldering pad (21) being isolated from said second ground plane with equal spacing at the two opposite sides of the soldering pad (21) to form a coplanar waveguide structure on the back-side of said plate, said first ground plane (12) having extension over said coplanar waveguide structure on the back-side of said plate and a predetermined area without metal being left on the front-side of said plate over said soldering pad (21), for compensating the mismatch of the characteristic impedance of said soldering pad (21) due to electrical discontinuity, said signal line further including a wire-bonding pad (11) on the front-side of said plate, and the wire-bonding pad (11) being made of metal and isolated from said first ground plane (12), and a metal-filled slot (15) imbedded in said plate for connecting the wire-bonding pad (11) and the soldering pad (21), said slot (15) having a larger cross-section than said via-holes (16).

2. A surface mountable microwave package as described in claim 1, further comprising two compensating via holes (14) filled with metal for connecting said first and second ground planes (12; 22) and situated in physical alignment with and at two opposite sides of the slot (15) with equal spacing between said first and second ground planes (12; 22) so that the capacitance of said metal-filled via slot (15) can be increased for compensating the mismatch of the characteristic impedance of said signal line due to electrical discontinuity.

3. A surface mountable microwave package as described in claim 1, wherein an integrated circuit ship is mounted on said first ground plane and wire-bonded to said wire-bonding pad (11).

4. A surface mountable microwave package as described in claim 1, wherein the gap between said wire-bonding pad (11) and said first ground plane (12) is tapered from a wider spacing near the slot (15) to a narrower spacing away from the slot (15).

5. A surface mountable microwave package as described in claim 4, wherein the width of said wire-bonding pad (11) is tapered from a wider width near the slot (15) to a narrower width away from the slot (15).

6. A surface mountable microwave package comprising: a dielectric plate, a first ground plane (12) of metal printed on the front-side of said plate, a second ground plane (22) of metal printed on the back-side of said plate, via holes (16) in said plate for connecting the first ground plane (12) to the second ground plane (22) with metal, at least an input/output port having a signal line including a soldering pad (21) of metal on the back-side of said plate, a wire-bonding pad (11) of metal on the front-side of said plate, and a metal-filled via slot (15) imbedded in said plate for connecting the wire-bonding pad (11) and the soldering pad (21), said slot (15) having a larger cross-section than said via holes (16); the impedance mismatch due to said wire-bonding pad (11), said soldering pad (21) and said slot (15) respectively being compensated by distributed capacitance with the first ground plane (12) and the second ground plane (22) to yield a matching impedance directly thereof.

7. A surface mountable microwave package comprising: a dielectric plate, a first ground plane (12) of metal printed on the front-side of said plate, a second ground plane (22) of metal printed on the back-side of said plate, via holes (16) in said plate for connecting the first ground plane (12) to the second ground plane (22) with metal, at least an input/output port having a signal line including a soldering pad (21) of metal on the back side of said plate, a wire-bonding pad (11) of metal on the front-side of said plate, and a plurality of metal-filled via holes (18) arranged in alignment from the top view of said dielectric plate, and parallely imbedded in said plate for connecting the wire-bonding pad (11) and the soldering pad (21), the impedance mismatch due to said wire-bonding pad (11), said soldering pad (21) and said plurality of metal-filled via holes (18) respectively being compensated by distributed capacitance with the first ground plane (12) and the second ground plane (22) to yield a matching impedance directly thereof.
